Europäisches Patentamt

European Patent Office

Office européen des brevets

(11) Publication number: **0 139 021**
**B1**

(12) EUROPEAN PATENT SPECIFICATION

(45) Date of publication of patent specification: 28.11.90

(21) Application number: 84901402.2

(22) Date of filing: 30.03.84

(86) International application number:
PCT/JP84/00152

(87) International publication number:
WO 84/03991 11.10.84 Gazette 84/24

(51) Int. Cl.⁵: **G 11 C 13/06**, G 11 C 11/14,
G 11 C 19/08, G 11 B 5/02,
G 11 B 11/10

(54) THERMOMAGNETIC OPTICAL RECORDING METHOD.

(30) Priority: 31.03.83 JP 55653/83
09.08.83 JP 145457/83
09.08.83 JP 145458/83

(43) Date of publication of application:
02.05.85 Bulletin 85/18

(45) Publication of the grant of the patent:
28.11.90 Bulletin 90/48

(84) Designated Contracting States:
DE FR GB NL

(56) References cited:
FR-A-2 155 954     JP-B-5 444 180
JP-A-5 023 762     JP-B-5 644 511
JP-A-5 817 505     US-A-3 739 360
JP-B-5 129 776     US-A-3 787 825

IBM TECHNICAL DISCLOSURE BULLETIN, vol.
13, no. 7, December 1970, pages 1788-1790, New
York, US; R.J. GAMBINO et al.: "Thermal
manipulation of bubble domains"
IBM TECHNICAL DISCLOSURE BULLETIN, vol.

(73) Proprietor: SONY CORPORATION
7-35 Kitashinagawa 6-Chome Shinagawa-ku
Tokyo 141 (JP)

(72) Inventor: TAMADA, Hitoshi Sony Corporation
7-35, Kitashinagawa 6-chome
Shinagawa-ku Tokyo 141 (JP)
Inventor: KANEKO, Masahiko Sony Corporation
7-35, Kitashinagawa 6-chome
Shinagawa-ku Tokyo 141 (JP)
Inventor: OKAMOTO, Tsutomu Sony
Corporation
7-35, Kitashinagawa 6-chome
Shinagawa-ku Tokyo 141 (JP)
Inventor: YAMADA, Toshiro Sony Corporation
7-35, Kitashinagawa 6-chome
Shinagawa-ku Tokyo 141 (JP)

(74) Representative: Cotter, Ivan John et al
D. YOUNG & CO. 10 Staple Inn
London WC1V 7RD (GB)

(56) References cited:

17, no. 7, December 1974, pages 2199-2200, New
York, US; J.H. EATON et al.: "Stamped
structures for bubble domain devices"

## Description

This invention relates to thermomagnetic recording.

A known thermomagnetic recording system uses a layer of soft magnetic material, having an easy axis of magnetisation normal to a surface of the layer, on which thermomagnetic recording is performed by irradiating it with laser light. The system is disclosed in our Japanese Patent Application Publication No. JP—A—57 158005 (Japanese Patent Application No. 56/45232). The layer of soft magnetic material used therein is for example, a YSmCaFeGe-series garnet, such as $(YSmCa)_3(FeGe)_5O_{12}$ or the like, having a strong uniaxial magnetic anisotropy in the direction normal to the surface of the layer and an easy axis of magnetisation normal to the surface of the layer. The layer is required to have such a soft magnetic property that, when the layer is used as a recording medium, the diameter of information bits to be written therein is practically determined only by a bias magnetic field, the coercive force of which is desired to be less than about 3 Oe, and preferably about 1 Oe (1 Oe = 79,59 A/m) or below. The layer is formed by growing a YSmCaFeGe-series garnet crystal or the like on a crystalline substrate of rare-earth gallium garnet, such as non-magnetic gadolinium gallium garnet (GGG), by liquid phase epitaxial (LPE) growth. The writing of information on the layer is carried out by first applying a bias magnetic field of a predetermined strength to the layer so as to magnetise the layer to have a single magnetic domain over the whole surface thereof and a direction of magnetisation which is perpendicular to the surface of the layer. Then, in this state, when an optical pulse is incident and focussed on the surface of the layer, the light energy is converted to heat energy so as to generate heat which forms bits (magnetic bubbles), whereby the writing of information on the layer is carried out. The bits thus written are cylindrical magnetic domains each having a predetermined diameter and a direction of magnetisation opposite to the applied bias magnetic field.

The strength of the bias magnetic field applied to the layer of soft magnetic material so as to produce a single magnetic domain therein over the whole surface thereof is selected to lie in a range from the run-out magnetic field to the collapse magnetic field of the material, for example between 57 Oe and 73 Oe for an LPE layer of $(YSmCa)_3(FeGe)_5O_{12}$. Because the coercive force, particularly the magnetic wall coercive force, of the layer is extremely small and, hence, the bias magnetic field applied thereto can be small, means for generating the bias magnetic field may be a small solenoid coil, a rubber magnet or the like.

Reading-out of information from a magnetised layer on which information has been recorded as set forth above is carried by irradiating the recorded medium with light, for example laser light which is linearly polarised by a polariser. When the linearly polarised light passes through the magnetised layer, it is subjected to rotation by the Faraday effect. The rotated light is then applied through an analyser to a photodetecting means so that an output corresponding to the information bits is produced therefrom, whereby reading-out of the information is performed.

According to the above-described technique of thermomagnetic recording on an LPE magnetic garnet thin film or layer, since its magnetic wall coercive force Hc is as small as about 1 Oe or less, the movement of information, which could not be carried out by prior art thermomagnetic recording techniques, namely Curie point writing, compensation point writing and so on, becomes possible. The movement of information comprises moving a recorded bit, namely a magnetic bubble domain, recorded at a certain position to another position so as thereby to provide a logic calculation function. According to a method of moving information bits disclosed in our Japanese Patent Application Publication No. JP—A—57 17505, a new bit independent from an information bit, namely a cue bubble, is produced by irradiation by continuous light, and a repulsion force between the cue bubble and the magnetic bubble of the already recorded information bit is used to move the information bit. That is, in order to move a desired information bit from a track along which the information bits are aligned, while applying a bias magnetic field between the run-out magnetic field and the collapse magnetic field to the recorded medium, substantially continuous light is made incident on a portion of the medium spaced from the track by a predetermined distance and the cue bit, which is produced in association with the continuous light, causes the information bit to be moved, the bit approaching the cue bubble due to the temperature gradient generated by the irradiation of light, to be repelled outside the track by a repulsive force therebetween. The substantially continuous light mentioned above includes, in addition to ordinary continuous light, light which is intermittent to such an extent that no recording is left even by the irradiation thereof, and may be any light if a pulse repetition rate of a beam is sufficiently faster than a relative speed between the magnetic thin film and the beam. The substantially continuous light is required always to make one bit, and the intensity thereof is preferably selected such that a bit to be moved, which is drawn towards the bit by the temperature gradient generated by the irradiation of light, is not pulled in but is repelled to a predetermined distance by the repulsive force. In this case, even if the intensity of the substantially continuous light is large, the repulsive force between the bits can be produced by adjusting the distance between the position at which the light is incident from the track from which the information bit is moved.

By means of the above method, it is possible to move the position of a recorded information bit. The position to which the information bit is moved is determined by the repulsive force between the bits, so that the position to which the information bit is moved is changed by the bias magnetic field. Also, the position to which the information bit is moved is changed by fluctuation of the coercive force Hc, so it is difficult to stabilise the position to which the information bit is moved.

material (in particular such a layer having a low magnetic wall coercive force) is carried out by the irradiation of light thereon, the present invention seeks to obviate the above defects and to enable an information bit to be stably moved to a predetermined position.

UK Patent Application Publication No. GB—A—1 392 974 (which corresponds to French Patent Application Publication No. FR—A—2 155 954) discloses a magnetic device comprising a plate of a magnetisable material having a preferred magnetisation direction which is transverse to the plane of the plate, means for applying a magnetic field transverse to the plane of the plate, and domain guide means, said plate having at least one portion of reduced thickness, said portion extending over a given length and having a stepped cross-section forming a continuous channel having a substantially constant width, wherein displaceable cylindrical domains exist under the influence of a magnetic field applied transverse to the plane of the plate, said domains having a magnetisation opposing the direction of the applied magnetic field and being displaceable by the domain guide means in the lengthwise direction of the continuous channel. The domains are displaceable between two portions of reduced thickness in the lengthwise direction in which the portions of reduced thickness extend. The portions of reduced thickness define a path of stable movement for the domains, which are displaced along the path by means of the thermal effect of light.

According to a first aspect of the invention there is provided a thermomagnetic recording apparatus comprising:

a layer of soft magnetic material capable of holding and moving cylindrical magnetic domains, said layer having an easy axis of magnetisation normal to a surface of the layer;

means for applying an external bias magnetic field to said layer to magnetise the layer in a direction of magnetisation;

means for irradiating said surface of said layer with a light beam so that a cylindrical magnetic domain magnetised in a direction opposite to said direction of magnetisation is formed in the layer;

said layer being provided with a region having different magnetic energy for the cylindrical magnetic domain than that of another region of the layer, said region of different magnetic energy having first and second corners connected to each other by a border of said region of different magnetic energy; and

means for causing the cylindrical magnetic domain, held at a first stable position within said region of different magnetic energy at said first corner thereof, to be moved along said border of said region of different magnetic energy to a second stable position within said region of different magnetic energy at said second corner thereof.

A first form of the means for causing movement of the cylindrical magnetic domain comprises means for irradiating said layer with a light beam in such a manner as to form another cylindrical magnetic domain at a position spaced by a predetermined distance from the first mentioned cylindrical magnetic domain held at said first stable position, and means for producing relative movement between said light beam forming said other cylindrical magnetic domain and said region of different magnetic energy so as thereby to move the first-mentioned cylindrical magnetic domain, positioned at said first stable position, along said border of said region of different magnetic energy to said second stable position.

A second form of the means for causing movement of the cylindrical magnetic domain comprises means for irradiating said layer with light at a position spaced by a predetermined distance from the domain to carry out local heating which causes a temperature difference across the ends of the domain, whereby the domain, positioned at said first stable position, is moved along said border of said region of different magnetic energy to said second stable position.

The region of different magnetic energy can be formed in the soft magnetic layer or film by forming a portion having a thickness less than that of the other region of the soft magnetic layer, or by selective ion implantation.

The soft magnetic layer can be made of soft magnetic garnet.

According to a second aspect of the invention there is provided a method of thermomagnetic recording, the method comprising:

applying an external bias magnetic field to a layer of soft magnetic material to magnetise the layer in a direction of magnetisation, the layer being capable of holding and moving cylindrical magnetic domains, and the layer having an easy axis of magnetisation normal to a surface of the layer;

irradiating said surface of said layer with a light beam so that a cylindrical magnetic domain magnetised in a direction opposite to said direction of magnetisation is formed in the layer;

said layer being provided with a region having different magnetic energy for the cylindrical magnetic domain than that of another region of the layer, said region of different magnetic energy having first and second corners connected to each other by a border of said region of different magnetic energy; and

moving the cylindrical magnetic domain, held at a first stable position within said region of different magnetic energy at said first corner thereof, along said border of said region of different magnetic energy to a second stable position within said region of different magnetic energy at said second corner thereof.

The invention will now be further described, by way of illustrative and non-limiting example, with reference to the accompanying drawings, in which:

Figure 1 is a schematically enlarged top view showing an example of a recording medium that can be used in a thermomagnetic recording system embodying the invention;

Figure 2 is a cross-sectional view of the recording medium;

3

In a thermomagnetic recording system in which thermomagnetic recording on a layer of soft magnetic

Figures 3(a) and 3(b) are diagrams showing a relationship between a region of a soft magnetic layer of the medium having different magnetic energy for a magnetic bubble than the remainder of the region and a force acting on a magnetic information bubble;

Figures 4(a) to 4(c) are diagrams useful for explaining movement of the bubble;

Figures 5 and 11 are graphs useful for explaining a relationship between a bias magnetic field and the power of laser light used for effecting movement;

Figure 6 is a pattern diagram useful for explaining the operation of a system embodying the invention;

Figures 7 to 9 are diagrams useful for explaining a logical calculation;

Figure 10 is a diagrammatic representation of the system embodying the invention;

Figure 12 is a pattern diagram useful for explaining the operation of a system embodying the invention; and

Figures 13 and 14 are graphs showing relationships between bias magnetic field and light power.

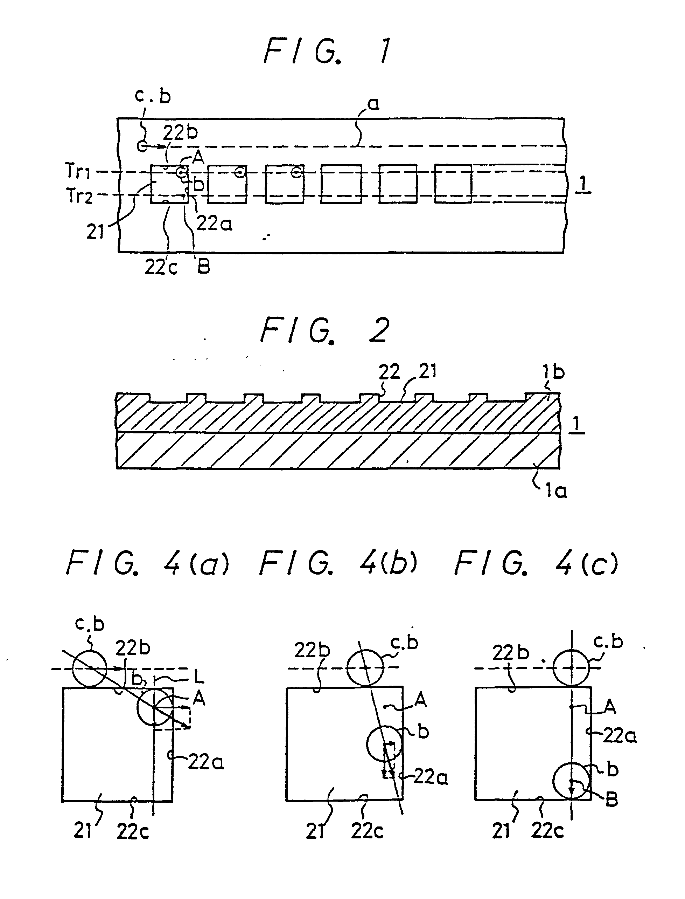

As shown by an enlarged top view in Figure 1 and by a cross-sectional view in Figure 2, a thin film of $(TmBi)_3(FeGa)_5O_{12}$ is grown by an LPE technique, to a thickness of 2.0 micrometres, on a garnet substrate 1a of $Gd_3Ga_5O_{12}$, so as to form a magnetic layer 1b of soft magnetic material having an easy axis of magnetisation normal to a surface of the layer, thereby forming a recording medium 1. A photolithographic technique is used to form, on the surface of the soft magnetic layer 1b, at a predetermined pitch, regions or portions 21 of square concave (recessed) shape which have a thickness less than those of other regions or portions of the layer and which have different magnetic energy for a magnetic bubble than those of the other portions. Reference numerals 22 designate steps formed at the edges (side walls) of each recessed region 21, the suffices a, b and c indicating the steps at particular ones of the edges of the recessed portion 21 oriented as shown in Figure 1. In this case, each region 21 is square and has sides which are 6 micrometres long. The depth of the regions 21 is selected to be 500 angstroms (50 nm) and the distance between the respective regions 21 is selected to be 4 micrometres.

An Ar ion laser (having a wavelength of 488 nm) having a writing power of 3.7 mW or more is used as a recording light source in such a manner that the laser light is focussed such that a beam spot on the soft magnetic layer 1b is 0.1 micrometres in diameter. Then, recording is carried out with a pulse width of 5 microseconds of the laser light to form an information bit, namely a first (information) cylindrical magnetic bubble (bubble domain) b within a region 21. In this case, the soft magnetic layer 1b had a saturation magnetisation of 17.2 emu/cm$^3$, a magnetic anisotropy field of 1100 Oe, a magnetic wall coercive force of 0.3 Oe and a magnetic bubble diameter of 2.4 micrometers under a bias magnetic field of 80 Oe. The soft magnetic layer 1b is irradiated with continuous laser light to form a second cylindrical magnetic bubble (bubble domain), namely a so-called cue magnetic bubble c.b, outside of the recessed region 21 and spaced from the information bit, namely the information magnetic bubble domain b formed within the region 21, as shown in Figure 1.

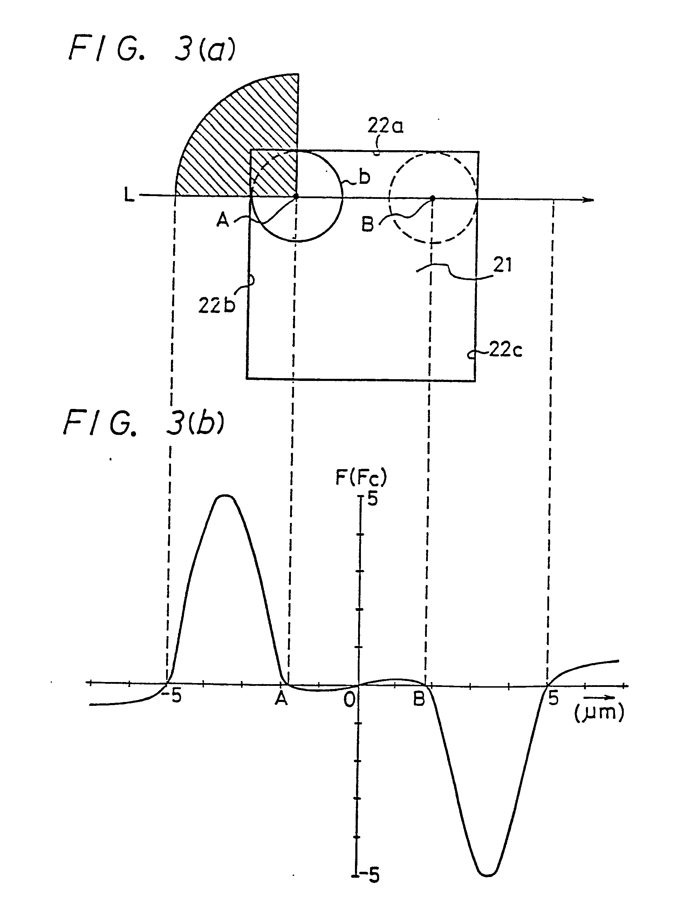

The information magnetic bubble b will now be considered in more detail. Figure 3 shows a relationship between the soft magnetic layer 1b (Figure 3(a)) which includes the recessed portion 21 having the above-mentioned dimensions and shape and a force F (Figure 3(b)) acting on the bit, namely the magnetic bubble b to be recorded thereon. As shown in Figure 3(a), a straight line L will be considered, which line extends along the step 22a at one side wall of the region 21 and is spaced from this side wall by a distance corresponding to the radius (1.2 micrometres) of the magnetic bubble b. The magnetic energy of the bubble changes at each position on the straight line L and the bubble is subjected to a force corresponding thereto. Figure 3(b) shows experimental results obtained for the force F acting on the magnetic bubble b along the line L, measured by the following method. The magnetic bubble b was moved along the line L by irradiating continuous laser light at a different position on the soft magnetic layer 1b. The minimum laser power which could move the magnetic bubble b against the force acting on the bubble at the steps 22b and 22c was measured. In other words, respective measurements were made of: the minimum laser power P1 for moving the bubble b from points A to B along the straight line L within the region 21 as shown in Figure 3(a); the minimum laser power P2 for moving the bubble from the inside of the region 21 to the outside of the region 21; and the minimum laser power P3 for moving the bubble from the outside of the region 21 into the region 21. Also, a measurement was made of the minimum laser power P0 for moving the bubble b against the magnetic wall coercive force Hc of the soft magnetic layer 1b at a place having no steps. That is, the force exerted on the bubble by the power P0 is equal to a force Fc (Fc = 4 dhMsHc) caused by the coercive force Hc. A force Fd for laser light to attract a bubble is given by:

$$Fd = \pi d^2 h (2\pi Ms) \left( CM\left(\frac{dMs}{dT}\right)/Ms - C\sigma\left(\frac{d\sigma w}{dT}\right)/\sigma w \right) . (\text{grad } T) \quad \ldots (1)$$

where d is the diameter of the bubble, h is the film thickness (thickness of the layer 1b), Ms is the saturation magnetisation, σw is the magnetic wall energy density, CM and Cσ are respective positive constants, and grad T is the temperature gradient formed by the irradiation by laser light. Although the average temperature of the bubble is increased by the irradiation by laser light, each of the components d, Ms, σw, CM and Cσ can be considered as having substantially a constant value in a range where the average temperature is not high as compared with the room temperature. As a result, the force Fd is proportional to the temperature gradient (grad T) or the laser light power. Consequently, if the ratio of the power P0 to each of the powers P1, P2 and P3 is calculated, it is possible to obtain the force F which is exerted from the step 22 due to the difference of the film (layer) thickness on the basis of the force Fc. Results calculated as set forth above are shown in Figure 3(b), which is a graph in which the abscissa indicates the position along the straight line L shown in Figure 3(a), in correspondence with Figure 3a, while the ordinate indicates the force F(Fc) which is exerted on the bubble b. A force F acting in the right-hand direction in Figure 3(a) is taken as being positive, while a force acting in the opposite direction is taken as being negative. From the graph of Figure 3(b), it is clear that within areas adjacent the outsides of the left-hand and right-hand edges of the region 21, namely from the steps 22b and 22c outward of the region 21 by about 2 micrometres, the bubble b is subjected to a force which pushes it back into the region 21, whereby the bubble is strongly restrained within the region 21. Further, it was confirmed that a magnetic bubble was stably formed at the point A, when the, writing light pulse was irradiated in an area shown hatched in Figure 3(a). The hatched area is one quarter of the area of a circle having a radius of 3.2 micrometres and centred at the point A, where the point A is remote from the side walls of the recessed region 21 having the steps 22a and 22b by a distance of 1.2 micrometres, which is the radius of the nucleated magnetic bubble. A similar feature occurs in each one of the four corners of the recessed region 21, because the shape of the region 21 is symmetrical.

Further, it was confirmed that the magnetic bubble b was so stably formed at each corner of the recessed region 21 that the magnetic bubble was in contact with the side walls in the region 21, even if the diameter of the magnetic bubble was varied by changing the bias magnetic field. For a magnetic bubble having diameter of 1.8 micrometres, the magnetic bubble was stably formed at the corner of the region 21 when a light pulse was irradiated in an area of one quarter of a circle having a diameter of 2.6 micrometres and centred at the centre of the bubble of stable position.

Within the recessed region 21, the influence on the magnetic bubble b caused by the difference of the film thickness (thickness of the layer lb) is so small that the bubble is easily moved from the point A to the point B.

The information magnetic bubble b formed as described above within the recessed region 21 can be moved to another position by a magnetic repulsive force generated between the bubbles c.b and b.

This repulsive force Fi is given by

$$Fi = 3/4(d/D)^4 \ (\pi hMs)^2 \qquad (2)$$

where D is the distance between the bubbles c.b and b.

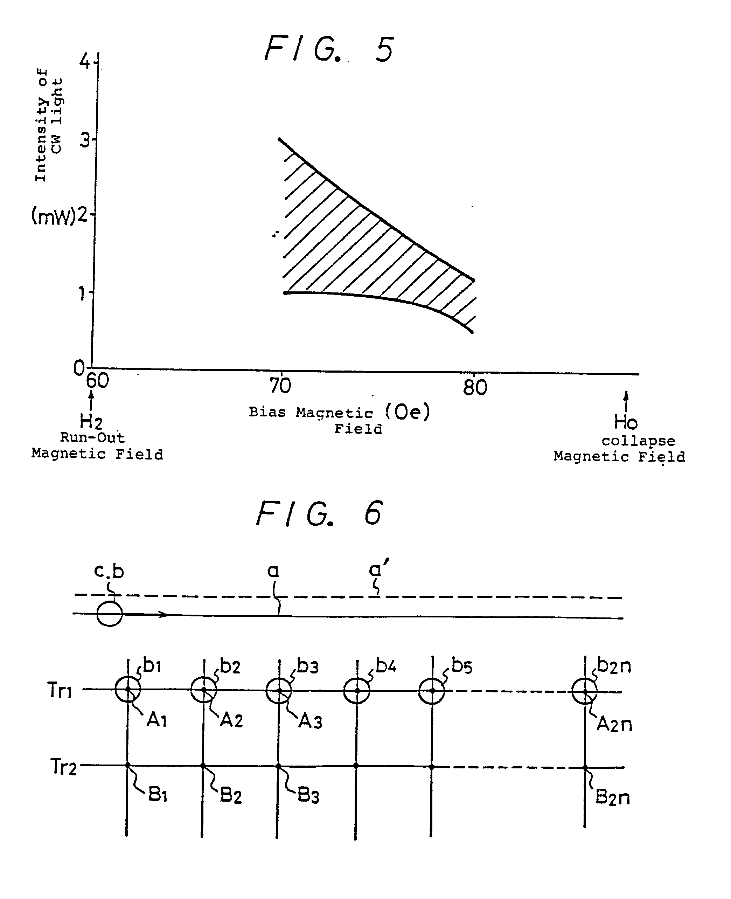

As shown in Figures 4(a) to 4(c), continuous laser light was made incident at a position spaced by a distance of 0.5 micrometres from the side wall of the recessed region 21 having the step 22b. When the position of incidence of this continuous laser light was moved relative to the region 21 along the step 22b in the direction from the left-hand side to the right-hand side as shown in Figure 4, the information bubble b was moved from the point A to the point B along the side wall having the step 22a. This movement could be stably carried out by means of continuous laser light (CW light) having a power ranging from 0.5 to 1.2 mW.

Figure 5 shows a relationship between the bias magnetic field and the power of the CW light, where the hatched area shows a region in which a stably formed magnetic bubble b can be moved from the point A to the point B when the bubble diameter is varied by changing the bias magnetic field.

The fact that the information magnetic bubble b can be moved from the point A (the first stable position) to the point B (the second stable position) along the side wall having the step 22a is carried out by the restraining force produced on the magnetic bubble at the step 22a. In a recording medium in which the recursed regions 21 are arranged along a straight line as shown in Figure 1, each point A in each region 21 lies on a first track Tr1 and each point B in each region 21 lies on a second track Tr2. If, as shown in Figure 6, the CW light, namely the cue bubble c.b, is moved along a straight line *a* spaced by a predetermined distance from the track Tr1, the information bubble b (b1, b2, b3 . . . b2n) at each point A (A1, A2, A3 . . . A2n) in each region 21, namely on the track Tr1, can be moved to each corresponding point B (B1, B2, B3 . . . B2n) within each region 21, namely on the track Tr2. It was confirmed that, in order to inhibit movement of the information bubbles b, it was necessary to displace the movement locus of the cue bubble c.b to trace a straight line *a* sufficiently distant from the regions 21 to inhibit the information bubbles from being moved.

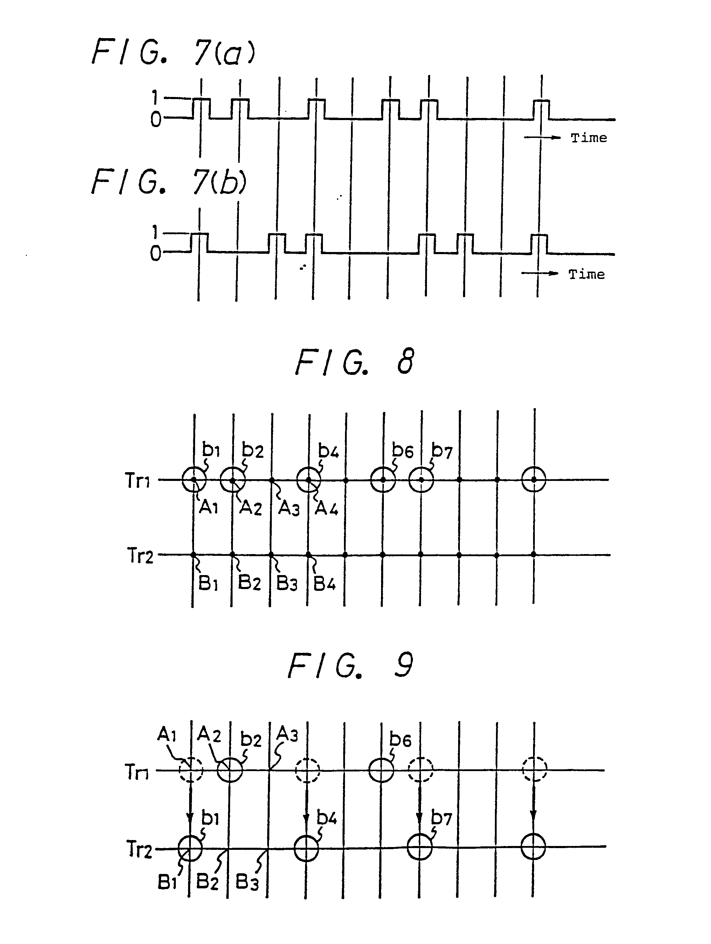

The facility to move an information bubble b from the track Tr1 to the track Tr2 makes it possible to carry out, for example, a logical calculation. First, a case in which an AND calculation function can be carried out by the present system will be described. Specifically, a description will be given of a case in which the logic calculation is carried out for two input signals having logic levels "0" and "1" as, for example, shown in Figures 7(a) and 7(b). On the basis of, for example, one input signal as shown in Figure 7(a), information recording bits are formed on the first track Tr1 at positions corresponding to the logic level "1" of the input signal by the method described above. That is, light pulses corresponding to the input signal shown in Figure 7a having the level "1" are used to form information bits b as shown in Figure 8. The CW light for movement is moved to the straight line *a* in correspondence with the logic level "1" in the second input signal as shown in Figure 7(b).

Thus, since (as shown in Figure 9) each recording bit on the track Tr1 is moved to the track Tr2 only if its position corresponds to a timing at which the signals shown in Figures 7(a) and 7(b) are both at logic level "1", reading out of the information bits moved to the track Tr2 provides an AND calculated output.

As described above, the layer 1b of soft magnetic material having an axis of easy magnetisation normal to the surface of the layer is formed on a garnet substrate 1a. If necessary, it is possible, for example, to deposit a non-reflective coating on the surface of the substrate 1a opposite to that having the layer 1b of soft magnetic material, and to deposit on the layer 1b a reflective film, such as an A1 evaporated film or the like, on which a protective film such as an $SiO_2$ film and so on are further formed.

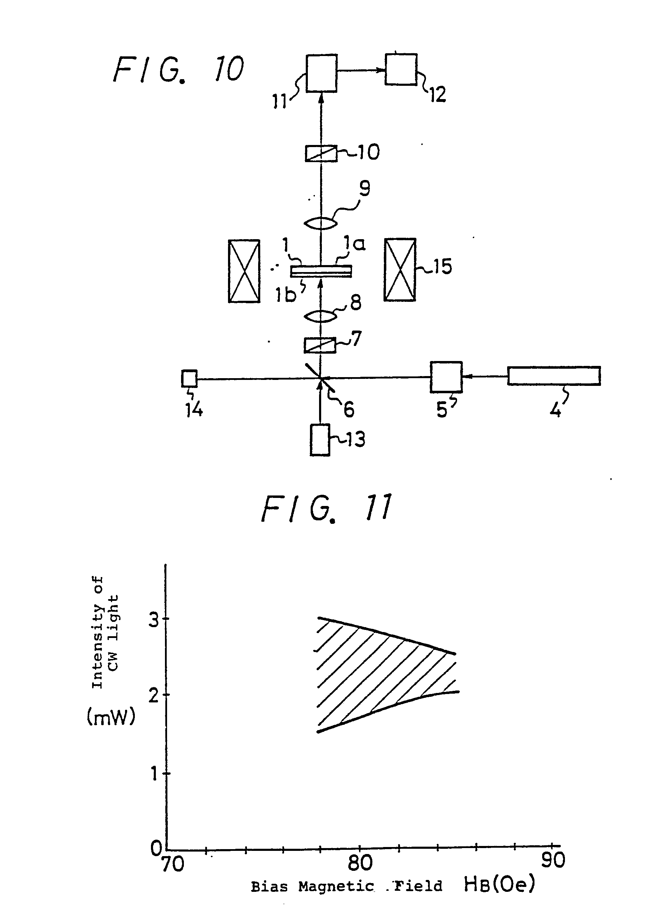

Figure 10 shows an apparatus or system for carrying out the thermomagnetic recording on the medium 1 and for reading the recorded information from the medium. In the apparatus, laser light emitted from an Ar ion laser 4 is passed through an optical modulator 5 which causes the light to be in pulse form or continuous, as required. The light from the modulator 5 is made incident on the layer 1b of soft magnetic material of the recording medium 1 via a half mirror 6, a polariser 7 and a condenser lens 8. The intensity of the light incident on the recording medium 1 is corrected and measured by a photodetector 14. Whether or not an information bit is recorded on the layer 1b and whether or not an information bit is moved to a predetermined position is decided as follows. Light from a mercury lamp 13 is irradiated on the layer 1b of the medium 1 through the half mirror 6, the polariser 7 and the condenser lens 8 and then focussed through an objective lens 9 and an analyser 10 on a television camera 11, the optical image formed thereon being observable by way of a monitor television receiver 12. The apparatus illustrated in Figure 10 also comprises a bias magnetic field generating means 15 formed, for example, by a permanent magnet. Though not shown, the medium 1 is mounted on a stage having a mechanism capable of being moved in two directions perpendicular to each other.

While in the above example the regions 21 of the soft magnetic layer 1b having different magnetic energy from that of the other regions or portions of the layer are formed by recessed portions, the regions 21 may instead be formed by ion implantation of the layer 1b. Such a region 21 formed by ion implantation may be formed by implanting, for example, hydrogen ions $H^+$ in a dosage amount of $1 \times 10^{15}$ (cm$^{-2}$) at an accelerating voltage of 70 keV.

The first cylindrical magnetic domain, namely the bubble b, can be moved from the first stable position (the point A) in a region 21 formed by such ion implantation to its second stable position (the point B) by the magnetic repulsive force acting between the cue bubble c.b and the information magnetic bubble b in similar manner to that described above. In this case, when the bias magnetic field was changed, the range of intensities of the CW light over which the bubble b could stably be moved from the point A to the point B was within an area shown hatched in the graph of Figure 11.

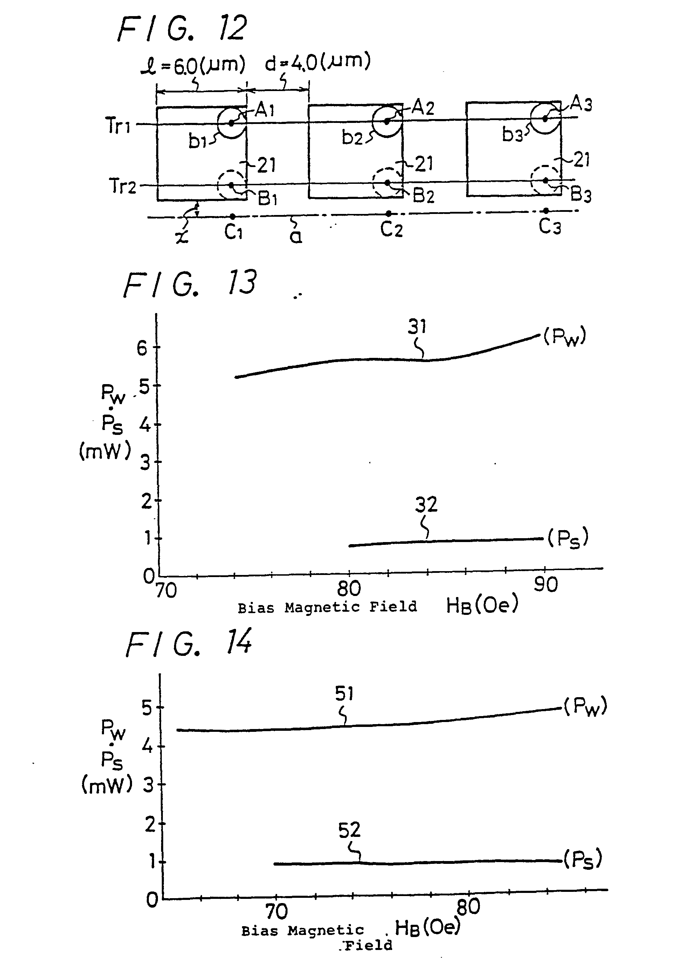

While in the above example the first cylindrical magnetic domain, namely the information magnetic bubble b, is moved from the first stable position (A) to the second stable position (B) by the second cylindrical magnetic domain, namely the cue bubble c.b, the bubble b located at the first stable position can instead be moved by irradiating the layer 1b with light at a position spaced from the bubble b by a predetermined distance, the light having an intensity sufficient to cause a temperature difference between the ends of the bubble. For example, by employing ion implantation as mentioned above, regions 21, each having different magnetic energy from that of the other portions of the layer 1b, were formed in line with one another, and the magnetic bubbles b (b1, b2, b3 . . .) were formed at positions A (A1, A2, A3 . . .) by a similar method to that described above, for example by light pulses from an Ar ion laser: see Figure 12. The magnetic bubbles b thereby produced were moved to other stable positions B (B1, B2, B3 . . .) by a temperature distribution produced within the soft magnetic layer 1b by irradiation by light pulses and hence by attractive forces attracting the magnetic bubbles to the positions irradiated by the light pulses. By way of example, by irradiating the light pulses at the positions B, the bubbles b (b1, b2, b3 . . .) recorded at the positions A are moved to the positions B. The relationship between the minimum power Ps necessary for the movement and the bias magnetic field HB was as shown by a curve 32 in the graph of Figure 13. Moreover, the relationship between the minimum power Pw necessary for recording the recording bubble b and the bias magnetic field HB was as shown by a curve 31 in the graph of Figure 13. Therefore, the range capable of the bit movement, namely the bit moving margin, was the area defined by the curves 31 and 32.

Next, with a bias magnetic field HB = 78 Oe and a moving pulse light power Ps = 4 mW, an investigation was conducted as to the consequences of the irradiation positions being displaced to points or positions C1, C2, C3 . . . which are opposed to the points B, which are spaced from the edges of the regions 21 by a distance x, and which lie on a line a shown chain-dotted in Figure 12. In this case, when the distance x was less than or approximately equal to 1.5 micrometres, the bubbles at the positions A1, A2, A3 . . . were stably moved to the positions B1, B2, B3 . . . . When the power Ps″ = 2 mW, the condition that the distance x was approximately equal to 0 micrometres was established. The reason why, even if the light pulses are irradiated on the positions C1, C2, C3 . . . , the bubbles remain (as mentioned above) at the positions B1, B2, B3 . . . , is based on the force F described with reference to Figure 3. That is, even if the irradiation position of the moving light pulse fluctuates, the position to which the bubble is moved is determined as any one of B1, B2, B3 . . . . That is, the positions to which the recording bits are moved were stabilised.

The above-described technique of movement of the bubbles b by temperature distribution can also be applied to the case in which the regions 21 are formed as the recessed portions, that is when the thickness of the regions 21 is reduced as compared with that of the other portions of the layer 1b as described above. In this case, the relationship between the minimum power Pw necessary for recording and the bias magnetic field HB was as shown by a curve 51 in the graph of Figure 14. However, in this case, the Ar ion laser (having the wavelength of 488 nm) was incident on the layer 1b of soft magnetic material for 5.0 microseconds with the diameter of the beam spot being selected to be about 1 micrometre or less. Next, the moving light pulse was made incident on the second stable position B so as thereby to move the bubble b recorded at the position A to the position B. In this case, the relationship between the minimum power Ps necessary for the movement and the bias magnetic field HB was as shown by a curve 52 in the graph of Figure 14. Therefore, in that case, the bit moving margin is the area defined by the curves 51 and 52. Then, with a bias magnetic field HB = 77 Oe and a moving light pulse power Ps = 4 mW, the irradiation positions were displaced to the positions C (C1, C2, C3 . . .) which are spaced from the edges of the regions 21 by the distance x, which are opposed to the positions B, and which lie on the chain-dotted line a. In this case, when the distance x was less than or equal to 1 micrometre, the bubbles at the positions A were stably moved to the positions B. Under the conditions that HB = 85 Oe and Ps = 4 mW, the conditions that x was less than or approximately equal to 0 micrometres was satisfied. In this case also, due to the action of the force as described with reference to Figure 3, the bubble b is moved along the side or edge of the region 21 and remains at the position B. Thus, as described above, even in the case where the regions 21 of different magnetic energy were formed by ion implantation, even if the position irradiated by the moving light pulse fluctuates, the position to which the bubbles was moved could be set at the position B and thus the position to which the recording bit was moved could be stabilised.

While, in the above examples, each region 21 formed as a recessed portion or by ion implantation or ion etching and the like is larger in size than the magnetic bubble b, in some cases the region 21 may be formed as various shapes such as square or rectangular and so on having width or side dimensions corresponding to or smaller than the diameter of the magnetic bubble b. In these cases also, the position of the magnetic bubble can be stabilised.

As set forth above, since each region 21 of different magnetic energy is formed in the layer 1b of soft magnetic material by an ion implantation technique or by making a recessed portion, the force acting on the magnetic bubble in accordance with the change of the magnetic energy is used to determine the position of the recording bubble whereby, even if there is a fluctuation such as a small scattering, vibration and so on in writing of the bubble, the formation of a cue bubble for movement, or the irradiation position of light for causing the temperature gradient it is nonetheless possible for stable operation to be achieved. As a result, design and manufacture of the apparatus can be simplified. Further, when the above-described apparatus techniques are applied to various logical calculations, a desired logical calculation can be carried out accurately without misoperation. Furthermore, since the position to which the bubble b is moved is determined precisely by the region 21, a disadvantage that the position to which the bubble is moved is changed by fluctuation of the coercive force Hc is avoided. Thus, great practical advantages of carrying out accurate readings and so on arise.

## Claims

1. A thermomagnetic recording apparatus comprising:
a layer (1b) of soft magnetic material capable of holding and moving cylindrical magnetic domains, said layer having an easy axis of magnetisation normal to a surface of the layer;
means (15) for applying an external bias magnetic field to said layer (1b) to magnetise the layer in a direction of magnetisation;
means (4) for irradiating said surface of said layer (1b) with a light beam so that a cylindrical magnetic domain (b) magnetised in a direction opposite to said direction of magnetisation is formed in the layer;
said layer (1b) being provided with a region (21) having different magnetic energy for the cylindrical magnetic domain than that of another region of the layer, said region (21) of different magnetic energy having first and second corners connected to each other by a border of said region of different magnetic energy; and
means for causing the cylindrical magnetic domain, held at a first stable position (A) within said region (21) of different magnetic energy at said first corner thereof, to be moved along said border of said region (21) of different magnetic energy to a second stable position (B) within said region (21) of different magnetic energy at said second corner thereof.

2. Apparatus according to claim 1, wherein said means for causing movement of the cylindrical magnetic domain (b) comprises means for irradiating said layer (1b) with a light beam in such a manner as to form another cylindrical magnetic domain (c.b) at a position spaced by a predetermined distance from the first-mentioned cylindrical magnetic domain (b) held at said first stable position (A), and means for producing relative movement between said light beam forming said other cylindrical magnetic domain and said region (21) of different magnetic energy so as thereby to move the first-mentioned cylindrical magnetic domain (b), positioned at said first stable position (A), along said border of said region (21) of different magnetic energy to said second stable position (B).

3. Apparatus according to claim 1, wherein said means for causing movement of the cylindrical magnetic domain (b) comprises means for irradiating said layer (1b) with light at a position spaced by a predetermined distance from the domain (b) to carry out local heating which causes a temperature difference across the ends of the domain, whereby the domain, positioned at said first stable position (A), is moved along said border of said region (21) of different magnetic energy to said second stable position (B).

4. Apparatus according to claim 1, claim 2 or claim 3, wherein said region (21) of different magnetic energy of said layer (1b) comprises a region of the layer which is thinner than said other region of the layer.

5. Apparatus according to claim 1, claim 2 or claim 3, wherein said region (21) of different magnetic energy of said layer (1b) is formed by selective ion implantation.

6. Apparatus according to any one of the preceding claims, wherein said layer (1b) is made of soft magnetic garnet.

7. A method of thermomagnetic recording, the method comprising:

applying an external bias magnetic field to a layer (1b) of soft magnetic material to magnetise the layer in a direction of magnetisation, the layer (1b) being capable of holding and moving cylindrical magnetic domains, and the layer having an easy axis of magnetisation normal to a surface of the layer;

irradiating said surface of said layer (1b) with a light beam so that a cylindrical magnetic domain (b) magnetised in a direction opposite to said direction of magnetisation is formed in the layer;

said layer (1b) being provided with a region (21) having different magnetic energy for the cylindrical magnetic domain than that of another region of the layer, said region (21) of different magnetic energy having first and second corners connected to each other by a border of said region of different magnetic energy; and

moving the cylindrical magnetic domain, held at a first stable position (A) within said region (21) of different magnetic energy at said first corner thereof, along said border of said region (21) of different magnetic energy to a second stable position (B) within said region (21) of different magnetic energy at said second corner thereof.

8. A method according to claim 7, wherein said movement of the cylindrical magnetic domain (b) is effected by irradiating said layer (1b) with a light beam in such a manner as to form another cylindrical magnetic domain (c.b) at a position spaced by a predetermined distance from the first-mentioned cylindrical magnetic domain (b) held at said first stable position (A), and bringing about relative movement between said light beam forming said other cylindrical magnetic domain and said region (21) of different magnetic energy so as thereby to move the first-mentioned cylindrical magnetic domain (b), positioned at said first stable position (A), along said border of said region (21) of different magnetic energy to said second stable position (B).

9. A method according to claim 7, wherein said movement of the cylindrical magnetic domain (b) is effected by irradiating said layer (1b) with light at a position spaced by a predetermined distance from the domain (b) to carry out local heating which causes a temperature difference across the ends of the domain, whereby the domain, positioned at said first stable position (A), is moved along said border of said region (21) of different magnetic energy to said second stable position (B).

10. A method according to claim 7, claim 8 or claim 9 wherein said region (21) of different magnetic energy of said layer (1b) comprises a region of the layer which is thinner than said other region of the layer.

11. A method according to claim 7, claim 8 or claim 9, wherein said region (21) of different magnetic energy of said layer (1b) is formed by selective ion implantation.

12. A method according to any one of claims 7 to 11, wherein said layer (1b) is made of soft magnetic garnet.

**Patentansprüche**

1. Thermomagnetische Aufzeichnungs-Vorrichtung, die umfaßt:

eine Schicht (1b) eines weichmagnetischen Materials, das in der Lage ist, zylindrische magnetische Domänen zu halten und zu bewegen, wobei die Schicht eine Achse leichter Magnetisierbarkeit senkrecht zu einer Oberfläche der Schicht hat,

ein Mittel (15) zum Anlegen eines äußeren Vormagnetisierungsfeldes an die Schicht (1b), um die Schicht in einer Magnetisierungsrichtung zu magnetisieren,

ein Mittel (4) zum Bestrahlen der Oberfläche der Schicht (1b) mit einem Lichtstrahl, so daß eine zylindrische magnetische Domäne (b), die in einer Richtung entgegengesetzt zu der Magnetisierungsrichtung magnetisiert ist, in der Schicht ausgebildet wird,

wobei die Schicht (1b) mit einer Zone (21) versehen ist, welche eine magnetische Energie für die zylindrische magnetische Domäne hat, die der magnetischen Energie einer anderen Zone der Schicht ungleich ist, und wobei die Zone (21) ungleicher magnetischer Energie erste und zweite Ecken hat, die durch eine Grenzlinie der Zone ungleicher magnetischer Energie miteinander verbunden sind, und

ein Mittel zum Veranlassen der zylindrischen magnetischen Domäne, die in einer ersten stabilen Position (A) innerhalb der Zone (21) ungleicher magnetischer Energie bei der ersten Ecke derselben gehalten ist, sich längs der Grenzlinie der Zone (21) ungleicher magnetischer Energie zu einer zweiten stabilen Position (B) innerhalb der Zone (21) ungleicher magnetischer Energie bei der zweiten Ecke derselben hin zu bewegen.

2. Vorrichtung nach Anspruch 1, bei der das Mittel zum Veranlassen der Bewegung der zylindrischen magnetischen Domäne (b) umfaßt: ein Mittel zum Bestrahlen der Schicht (1b) mit einem Lichtstrahl in einer

8

Weise, daß eine weitere zylindrische magnetische Domäne (c.b) bei einer Position gebildet wird, die um einen vorbestimmten Abstand von der erstgenannten zylindrischen magnetischen Domäne (b), welche bei der ersten stabilen Position (A) gehalten ist, entfernt ist, und ein Mittel zum Erzeugen einer Relativbewegung zwischen dem Lichtstrahl, der die andere zylindrische magnetische Domäne bildet, und der Zone (21) ungleicher magnetischer Energie, um dadurch die erstgenannte zylindrische magnetische Domäne (b), die bei der ersten stabilen Position (A) angeordnet ist, längs der Grenzlinie der Zone (21) ungleicher magnetischer Energie zu der zweiten stabilen Position (B) hin zu bewegen.

3. Vorrichtung nach Anspruch 1, bei der das Mittel zum Veranlassen der Bewegung der zylindrischen magnetischen Domäne (b) ein Mittel umfaßt zum Bestrahlen der Schicht (1b) mit einem Licht in einer Position, die um einen vorbestimmten Abstand von der Domäne (b) entfernt ist, um eine lokale Aufheizung auszuführen, die eine Temperaturdifferenz über den Enden der Domäne bewirkt, wodurch die Domäne, die in der ersten stabilen Position (A) angeordnet ist, längs der Grenzlinie der Zone (21) ungleicher magnetischer Energie zu der zweiten stabilen Position (B) hin bewegt wird.

4. Vorrichtung nach Anspruch 1, 2 oder 3, bei der die Zone (21) ungleicher magnetischer Energie der Schicht (1b) aus einer Zone der Schicht besteht, die dünner als die andere Zone der Schicht ist.

5. Vorrichtung nach Anspruch 1, 2 oder 3, bei der die Zone (21) ungleicher magnetischer Energie der Schicht (1b) durch selektive Ionenimplantation gebildet ist.

6. Vorrichtung nach einem der vorhergehenden Ansprüche, bei der die Schicht (1b) aus weichmagnetischem Granat hergestellt ist.

7. Verfahren zur thermomagnetischen Aufzeichnung, welches Verfahren Schritte umfaßt zum

Anlegen eines äußeren Vormagnetisierungsfeldes an eine Schicht (1b) aus weichmagnetischem Material, um die Schicht in einer Magnetisierungsrichtung zu magnetisieren, wobei die Schicht (1b) in der Lage ist, zylindrische magnetische Domänen zu halten und zu bewegen, und wobei die Schicht eine Achse leichter Magnetisierbarkeit hat, die senkrecht zu einer Oberfläche der Schicht verläuft,

Bestrahlen der Oberfläche der Schicht (1b) mit einem Lichtstrahl, so daß eine zylindrische magnetische Domäne (b), die in einer Richtung entgegengesetzt zu der Magnetisierungsrichtung magnetisiert ist, in der Schicht gebildet wird,

wobei die Schicht (1b) mit einer Zone (21) versehen ist, die eine magnetische Energie für die zylindrische magnetische Domäne hat, die ungleich der magnetischen Energie einer anderen Zone der Schicht ist, und wobei die Zone (21) ungleicher Energie erste und zweite Ecken hat, die durch eine Grenzlinie der Zone ungleicher magnetischer Energie miteinander verbunden sind, und

Bewegen der zylindrischen magnetischen Domäne, die bei einer ersten stabilen Position (A) innerhalb der Zone (21) ungleicher magnetischer Energie bei deren erster Ecke gehalten ist, längs der Grenzlinie der Zone (21) ungleicher magnetischer Energie zu einer zweiten stabilen Position (B) innerhalb der Zone (21) ungleicher magnetischer Energie bei der zweiten Ecke derselben hin.

8. Verfahren nach Anspruch 7, bei dem die Bewegung der zylindrischen magnetischen Domäne (B) bewirkt wird durch

Bestrahlen der Schicht (1b) mit einem Lichtstrahl in einer Weise, um eine weitere zylindrische magnetische Domäne (c.b) bei einer Position zu bilden, die um einen vorbestimmten Abstand von der erstgenannten zylindrischen magnetischen Domäne (b), welche bei der ersten stabilen Position (A) gehalten ist, entfernt ist, und

Erzeugen einer relativen Bewegung zwischen dem Lichtstrahl, der die andere zylindrische magnetische Domäne bildet, und der Zone (21) ungleicher magnetischer Energie, um dadurch die erstgenannte zylindrische magnetische Domäne (b), die bei der ersten stabilen Position (A) angeordnet ist, längs der Grenzlinie der Zone (21) ungleicher magnetischer Energie zu der zweiten stabilen Position (B) hin zu bewegen.

9. Verfahren nach Anspruch 7, bei dem die Bewegung der zylindrischen magnetischen Domäne (b) durch Bestrahlen der Schicht (1b) mit einem Licht bei einer Position bewirkt wird, die um einen vorbestimmten Abstand von der Domäne (b) entfernt ist, um eine lokale Aufheizung auszuführen, die eine Temperaturdifferenz über den Enden der Domäne verursacht, wodurch die Domäne, die bei der ersten stabilen Position (A) angeordnet ist, längs der Grenzlinie der Zone (21) ungleicher magnetischer Energie zu der zweiten stabilen Position (B) hin bewegt wird.

10. Verfahren nach Anspruch 7, 8 oder 9, bei dem die Zone (21) ungleicher magnetischer Energie der Schicht (1b) aus einer Zone der Schicht besteht, die dünner als die andere Zone der Schicht ist.

11. Verfahren nach Anspruch 7, 8 oder 9, bei dem die Zone (21) ungleicher magnetischer Energie der Schicht (1b) durch selektive Ionenimplantation gebildet wird.

12. Verfahren nach einem der Ansprüche 7 bis 11, bei dem die Schicht (1b) aus weichmagnetischem Granat hergestellt wird.

**Revendications**

1. Appareil d'enregistrement thermomagnétique comportant:
une couche (1b) de matériau magnétique doux capable de retenir et de déplacer des domaines magnétiques cylindriques, ladite couche présentant un axe de magnétisation facile normal à une surface de la couche;

des moyens (15) pour appliquer un champ magnétique de polarisation extérieur à ladite couche (1b) pour magnétiser la couche dans une direction de magnétisation;

des moyens (4) pour éclairer ladite surface de ladite couche (1b) avec un faisceau lumineux de façon telle qu'un domaine magnétique cylindrique (b), magnétisé dans une direction opposée à ladite direction de magnétisation, se forme sur la couche;

ladite couche (1b) comprenant une région (21) qui présente, pour le domaine magnétique cylindrique, une énergie magnétique différente de celle qu'elle présente pour une autre région de la couche, ladite région (21) d'énergie magnétique différente présentant un premier et un second coins reliés l'un à l'autre par une frontière de ladite région d'énergie magnétique différente; et

des moyens pour faire en sorte que le domaine magnétique cylindrique, retenu à une première position stable (A) dans ladite région (21) d'énergie magnétique différente, audit premier coin de cette région, se déplace le long de ladite frontière de ladite région (21) d'énergie magnétique différente pour venir à une seconde position stable (B) dans ladite région (21) d'énergie magnétique différente, audit second coin de cette région.

2. Appareil selon la revendication 1, dans lequel lesdits moyens prévus pour provoquer le déplacement du domaine magnétique cylindrique (b) comportent des moyens pour éclairer ladite couche (1b) avec un faisceau lumineux de façon à former un autre domaine magnétique cylindrique (c.b) à une position espacée d'une distance prédéterminée du domaine magnétique cylindrique (b), mentionné en premier lieu et retenu à ladite première position stable (A), et des moyens pour produire un déplacement relatif entre ledit faisceau lumineux, qui forme ledit autre domaine magnétique cylindrique, et ladite région (21) d'énergie magnétique différente, de façon, de ce fait, à déplacer le domaine magnétique cylindrique (b) mentionné en premier lieu et positionné à ladite première position stable (A), le long de ladite frontière de ladite région (21) d'énergie magnétique différente, pour venir à ladite seconde position stable (B).

3. Appareil selon la revendication 1, dans lequel lesdits moyens prévus pour provoquer le déplacement du domaine magnétique cylindrique (b) comporte des moyens pour éclairer ladite couche (1b) avec un faisceau lumineux en une position espacée, d'une distance prédéterminée, du domaine (b), pour exercer un chauffage local qui provoque une différence de température de part et d'autre des extrémités du domaine, ce par quoi le domaine, positionné à ladite première position stable (A), se déplace le long de ladite frontière de ladite région (21) d'énergie magnétique différente pour venir a ladite seconde position stable (B).

4. Appareil selon la revendication 1, la revendication 2 ou la revendication 3, dans lequel ladite région (21), d'énergie magnétique différente, de ladite couche (1b) comporte une région de la couche qui est plus fine que ladite autre région de la couche.

5. Appareil selon la revendication 1, la revendication 2 ou la revendication 3, dans laquelle ladite région (21), d'énergie magnétique différente, de ladite couche (1b) est formée par une implantation d'ions sélective.

6. Appareil selon l'une quelconque des revendications précédentes, dans lequel ladite couche (1b) est faite d'un cristal ferromagnétique doux.

7. Procédé d'enregistrement thermomagnétique, le procédé comportant le fait de:

appliquer un champ magnétique de polarisation extérieur à une couche (1b) de matériau magnétique doux pour magnétiser la couche dans une direction de magnétisation, la couche (1b) étant capable de retenir et de déplacer les domaines magnétiques cylindriques et la couche présentant un axe de magnétisation facile normal à une surface de la couche;

éclairer ladite surface de ladite couche (1b) avec un faisceau lumineux de façon qu'un domaine magnétique cylindrique (b), magnétisé dans une direction opposée à ladite direction de magnétisation, se forme dans la couche;

ladite couche (1b) comprenant une région (21) présentant, pour le domaine magnétique cylindrique, une énergie magnétique différente de celle d'une autre région de la couche, ladite région (21) d'énergie magnétique différente présentant un premier et un second coins reliés l'un à l'autre par une frontière de ladite région d'énergie magnétique différente; et

déplacer le domaine magnétique cylindrique, retenu à une première position stable (A) dans ladite région (21) d'énergie magnétique différente, à son dit premier coin, le long de ladite frontière de ladite région (21) d'énergie magnétique différente, pour venir à une seconde position stable (B) dans ladite région (21) d'énergie magnétique différente, à son dit second coin.

8. Procédé selon la revendication 7, dans lequel ledit déplacement du domaine magnétique cylindrique (b) s'effectue par éclairement de ladite couche (1b) avec un faisceau lumineux de façon à former un autre domaine magnétique cylindrique (c.b) à une position espacée, d'une distance prédéterminée, du domaine magnétique cylindrique (b) mentionné en premier lieu et retenu à ladite première position stable (A), et en faisant effectuer un déplacement relatif entre ledit faisceau lumineux, qui forme ledit autre domaine magnétique cylindrique, et ladite région (21) d'énergie magnétique différente, de façon à déplacer le domaine magnétique cylindrique (b) mentionné en premier lieu et positionné à ladite première position stable (a), le long de ladite frontière de ladite région (21) d'énergie magnétique différente, pour venir à ladite seconde position stable (B).

9. Procédé selon la revendication 7, dans lequel ledit déplacement du domaine magnétique cylindrique (b) s'effectue en éclairant ladite couche (1b) avec un faisceau lumineux à une position espacée, d'une distance prédéterminée, du domaine (b) pour exercer un chauffage local qui provoque une différence de température de part et d'autre des extrémités du domaine, ce par quoi le domaine, positionné à ladite première position stable (A), se déplace le long de ladite frontière de ladite région (21) d'énergie magnétique différente pour venir à ladite seconde position stable (B).

10. Procédé selon la revendication 7, la revendication 8, ou la revendication 9, dans lequel ladite région (21) d'énergie magnétique différente, de ladite couche (1b) comporte une region de la couche qui est plus fine que ladite autre région de la couche.

11. Procédé selon la revendication 7, la revendication 8 ou la revendication 9, dans lequel ladite région (21), d'énergie magnétique différente, de ladite couche (1b) est formée par une implantation d'ions sélective.

12. Procédé selon l'une quelconque des revendications 7 à 11, dans lequel ladite couche (1b) est faite d'un cristal ferromagnétique doux.

FIG. 1

FIG. 2

FIG. 4(a)  FIG. 4(b)  FIG. 4(c)

1

FIG. 3(a)

22a

L

b

A

B

22b

21

22c

FIG. 3(b)

F(Fc)

5

-5          A     0     B          5
                                    (μm)

-5

# FIG. 5

Intensity of CW light

(mW)

Bias Magnetic (Oe) Field

H2
Run-Out
Magnetic Field

Ho
collapse
Magnetic Field

# FIG. 6

3

## FIG. 7(a)

## FIG. 7(b)

## FIG. 8

## FIG. 9

*FIG. 10*

*FIG. 11*

## F I G. 12

$\ell = 6.0 (\mu m)$   $d = 4.0 (\mu m)$

## F I G. 13

Bias Magnetic Field   $H_B(Oe)$

## F I G. 14

Bias Magnetic Field   $H_B(Oe)$